Europäisches Patentamt

European Patent Office

Office européen des brevets

(11) Publication number: **0 260 058**
**A1**

## EUROPEAN PATENT APPLICATION

(21) Application number: 87307754.9

(22) Date of filing: 02.09.87

(51) Int. Cl.⁴: **H01L 21/285**, H01L 21/00, H01L 29/72

(30) Priority: 08.09.86 GB 8621535

(43) Date of publication of application:
16.03.88 Bulletin 88/11

(84) Designated Contracting States:
AT BE CH DE ES FR GB GR IT LI LU NL SE

(71) Applicant: BRITISH TELECOMMUNICATIONS
PUBLIC LIMITED COMPANY
81 Newgate Street
London EC1A 7AJ(GB)

(72) Inventor: Welbourn, Anthony David
7 Fishbane Close
Ipswich Suffolk IP3 0SE(GB)
Inventor: Heslop, Christopher John Hedley
7 Viking Heights
Martlesham Woodbridge Suffolk IP12
4RT(GB)

(74) Representative: Roberts, Simon Christopher
et al
BRITISH TELECOM Intellectual Property Unit
13th Floor 151, Gower Street
London, WC1E 6BA(GB)

(54) Self-aligned bipolar fabrication process.

(57) Bipolar transistors are made by forming a base window through a dielectric layer overlying a substrate. In the wall of the base window a polysilicon layer is exposed. Subsequent processing involves the forming of various sidewall spacers within the base window to define the base and emitter regions. Since spacer formation requires no lithographic processing, there is no need to define very small features, such as the emitter, lithographically. The smallest feature which needs to be defined lithographically is the original base window which may be between 1 and 2 microns for emitter widths of 0.5 um or less.

Fig. 4.

## SELF-ALIGNED BIPOLAR FABRICATION PROCESS

This invention relates to bipolar semiconductor devices and to processes for their fabrication.

Bipolar devices fabricated using known processes are limited in terms of performance by base resistance and capacitance. If the performance of bipolar devices is to be improved, it will be necessary to reduce the area of the base. Considerable attention has already been given to the reduction of base area and the scope for further reduction is severely limited by alignment tolerances for the base and emitter contacts and the limits of resolution of the lithographic process. Consequently there exists a need for an improved fabrication process which will enable the fabrication of bipolar devices having bases of reduced area without the need to define small device dimensions lithographically.

The present invention seeks to provide an improved fabrication method by means of which the base contact area can be reduced with consequent improvements in device performance.

Throughout this specification the term 'substrate', unless the context clearly requires otherwise, is used to refer to the semiconductor in which the active areas of the transistor are grown and includes any epitaxial semiconductor layers in which active regions are formed.

According to a first aspect of the present invention there is provided a method of fabricating a bipolar transistor comprising emitter, base and collector regions in a semiconductor substrate, the method comprising the steps of: a) forming a base window through a dielectric layer to the substrate, the sidewall of the window comprising an electrically conductive portion insulated from the substrate; b) forming, non-lithographically, an annular body of conductive material about the inner periphery of the sidewall and in contact with both the substrate and said conductive portion; c) forming, non-lithographically, the base and emitter regions within the area defined by the inner periphery of said annular body.

The advantage of this method is that the base window is the smallest feature of the transistor which needs to be defined directly by lithography. Smaller features such as the emitter are automatically aligned relative to the base window, so that even for sub-micron emitter size the smallest dimension for which photolighography need be used can be in excess of 1 micron. A 2 micron base window, for example, results in the formation of a half micron emitter.

Preferably the annular body of conductive material is doped polysilicon, as polysilicon can readily be oxidised to produce a dielectric, and the dopant can be driven into the substrate to provide precisely aligned base contacts.

Preferably also the non-lithographic processes used to produce the annular body and subsequently used to define the emitter and base regions are anisotropic etching processes to produce sidewall spacers.

The method according to the invention also has the advantage that the base and emitter are each implanted very late in the processing sequence, which means that there is a minimum of unwanted diffusion and hence more precise control of doping profiles can be achieved.

Embodiments of the invention will now be described with reference to the accompanying drawings in which:

Figure 1 is a diagrammatic representation of a cross-section through a partially completed bipolar device;

Figure 2 is a further diagrammatic cross-section corresponding to the device of Figure 1 at a later stage;

Figure 3 is a further diagrammatic cross-section of the device at a later stage of fabrication;

Figure 4 is a final diagrammatic cross-section of the device after formation of the emitter contact.

The new process starts with a silicon wafer (1) which has been conventionally processed to give a buried layer (2), an $n^+$ collector sinker (3) and device isolation (4) (which could for example be junction or trench isolation). The surface oxide is removed.

The initial processing sequence, together with approximate layer thicknesses is as follows:

An initial oxide layer (5) of about 500nm is grown over the entire surface of the wafer. Next a polysilicon layer (6) about 300nm thick is grown over the initial oxide layer. The polysilicon layer is doped (by diffusion or implantation) with boron to give it a high conductivity (about $1E20/cm^3$ peak level). A resist layer is deposited and a pattern defined lithographically. Optionally a silicide may be formed on the polysilicon. The polysilicon layer is then etched, using the patterned resist layer as a mask, to produce polysilicon islands which will subsequently form the part of the base contact which the metallisation layer will contact. The collector contact windows are then opened through the oxide (5) following a conventional lithographic pattern definition process.

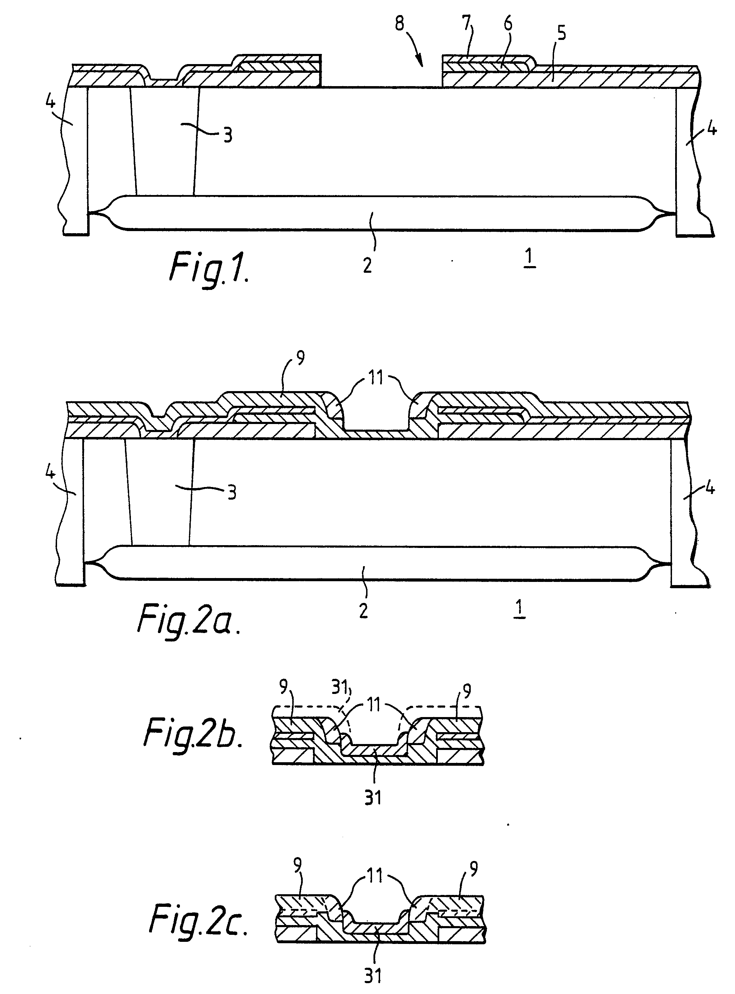

A second oxide layer (7), about 200nm thick, is then deposited over the surface of the wafer. Finally, the base window (8) is opened, again following conventional lithographic processing through the oxide and polysilicon layers to the surface of the wafer. The resulting structure is shown in cross-section in Figure 1. It is important that there is little or no undercutting of the polysilicon relative to the oxide, since the polysilicon is to make intimate contact with the subsequently deposited layer.

The next step is to deposit conformally a second polysilicon layer (9) over the wafer to a depth of about 500 nm. The second polysilicon layer should be deposited in intimate contact with that part of the first polysilicon layer exposed on the walls of the base window. This second polysilicon layer is heavily doped (to about $1E20/cm^3$ peak concentration) with boron, ideally during its deposition, but alternatively by diffusion following deposition.

Over the second polysilicon layer (9) a layer of oxide (10) is deposited. As the oxide does not deposit conformally, it tends to be thicker at the lower periphery of the base window. This pattern of deposition is in fact actually sought, because the oxide layer (10) is subsequently etched anisotropically, using plasma etching, to form 'spacers' (11) within the base window as shown in Figure 2, which will subsequently define the emitter window.

After the formation of the spacers (11) the heavily doped upper layer of the second polysilicon layer (9) is removed by the plasma etching. The cross-section at this stage is as shown in Figure 2.

The exposed polysilicon is then thermally oxidised. The object here is effectively to remove the polysilicon which overlies the oxide layer (7) and that in the emitter window. While the polysilicon is being oxidised, boron from the polysilicon on the base window sidewall is driven into the silicon on the wafer to form $p^+$ contacts. Depending upon the precise geometry chosen, a simple oxidation step may be utilised. Alternatively differential oxidation between the emitter window and surrounding areas would be possible by depositing and planarising a nitride layer. This process is best explained by reference to Figures 2b and 2c. In Figure 2b, the nitride layer (31) is shown in the partially etched, planarised state. As can be seen, the nitride layer (31) has been etched back to a stage where the oxide spacers (11) are partly exposed. The exposed polysilicon (9) is then oxidised until the entire thickness of the upper layer has been oxidised, leaving a polysilicon spacer underneath. The nitride layer is then stripped off and the polysilicon in the emitter window is oxidised.

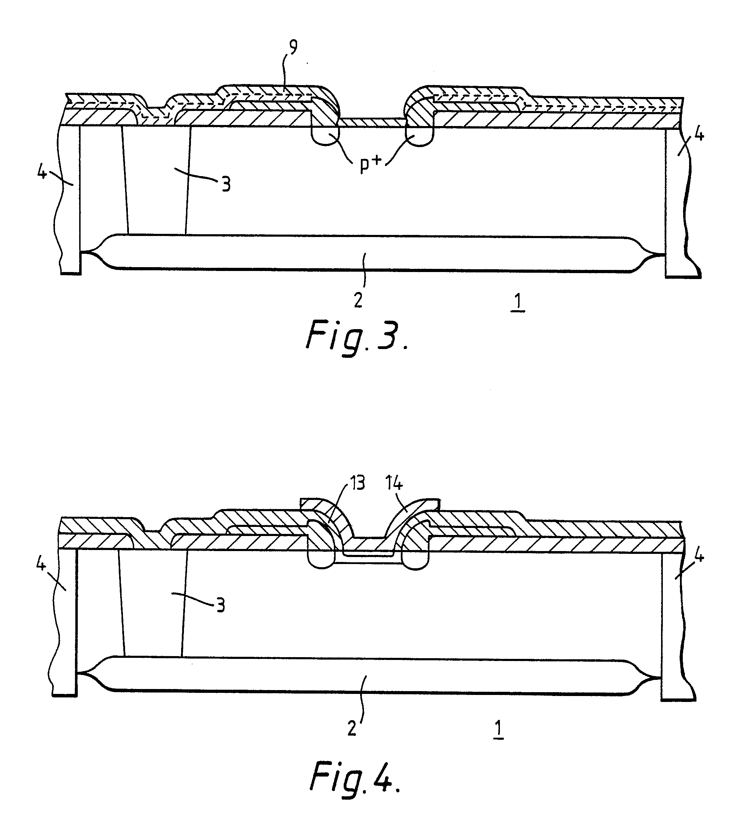

Due to the differences in thickness between the polysilicon layer in the emitter window and that previously over the oxide layer (7), as well as the differences in their treatment, the oxide thickness on top of the polysilicon spacer is much greater than that in the emitter window. Thus when the oxide has been etched from the emitter window planty of oxide still remains on top of the polysilicon spacer so that it does not short to the emitter polysilicon which will subsequently be deposited. In either case, the polysilicon will of course increase in volume as it is oxidised and this is likely to disrupt the profile in the base window and some HF dip cleaning will probably be necessary. The cross-section of the device at this stage is shown in Figure 3.

The oxide overlying the wafer in the emitter window is removed by plasma etching. The base can be implanted at this stage. Another oxide coating (12) is deposited and etched to form spacers (13) within the emitter window. If the base has not already been implanted it is done at this stage, subsequent diffusion ensuring that the base and base contacts are adequately connected. A layer of polysilicon (14) which is to form the emitter contact is next deposited. The emitter polysilicon is doped $n^+$ during or after deposition, and a thin emitter formed by driving dopant from the emitter polysilicon into the substrate. The emitter contact is then defined lithographically as usual. The cross-section at this stage is shown in Figure 4.

Subsequent processing, including the deposition of an oxide layer, cutting contacts to the base, emitter polysilicon and the collector sinker, is conventional.

In a further variant according to the invention, the above described process can be followed until the oxide has been stripped from the substrate after the stage shown in Figure 3. Then molecular beam epitaxy (MBE) is used to grow a further epitaxial layer of suitably dopant silicon on the substrate, to form the base. Subsequently a further epitaxial layer can be grown by MBE to form the emitter. The process of forming the epitaxial layers is relatively straightforward, since the only exposed silicon is that on the floor of the base contact window.

## Claims

1. A method of fabricating a bipolar transistor comprising emitter, base and collector regions in a semiconductor substrate, the method comprising the steps of: a) forming a base window through a dielectric layer to the substrate, the sidewall of the window comprising an electrically conductive portion insulated from the substrate; b) forming, non-lithographically, an annular body of conductive material about the inner periphery of the sidewall and in contact with both the substrate and said conductive portion; c) forming, non-lithographically, the base and emitter regions within the area defined by the inner periphery of said annular body.

2. A method as claimed in claim 1 wherein said annular body comprises doped polysilicon, the method further comprising the step of forming base contacts by driving dopant from the body into the substrate under the body.

3. A method as claimed in claim 1 or claim 2 wherein said body is made by producing a conformal coating of the conductive material over said dielectric layer; forming a second dielectric layer over the conductive material; anisotropically etching the second dielectric layer to expose the conductive material at least around the base window and on the floor of the base window, leaving an annular body of dielectric around the inner periphery of the conductive material coating the side walls of the base window; and carrying out an oxidation reaction to convert the exposed areas of the conductive coating into a dielectric to leave said annular body of conductive material about the inner periphery of the side wall and in contact with both the substrate and said conductive portion.

4. A method as claimed in any one of the preceding claims, wherein the base and emitter regions are grown using molecular beam epitaxy.

5. A method as claimed in claim 3 wherein the method further comprises the steps of: etching, without a lithographic mask, to remove the dielectric across the floor of the base window to expose the substrate; forming, non-lithographically, a further annular body of dielectric material around the inner periphery of the base window as then composed, a portion of the substrate being exposed within the inner periphery of said further annular body; and implanting the base within the substrate exposed before or after the formation of said further annular body of dielectric.

6. A method as claimed in claim 5 further comprising the step of: forming an emitter in the substrate portion exposed within the inner periphery of said further annular body by forming a body of doped polysilicon within the inner periphery of said further annular body and driving dopant from the body into the substrate.

7. A bipolar transistor made according to the method of any one of the preceding claims.

8. A bipolar transistor substantially as hereinbefore described with reference to and as shown in the accompanying drawings.

9. An integrated circuit comprising a plurality of bipolar transistors as claimed in claim 7 or claim 8.

0 260 058

Fig.1.

Fig.2a.

Fig.2b.

Fig.2c.

Fig.3.

Fig.4.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 180 256 (N.V. PHILIPS' GLOEILAMPENFABRIEKEN) <br> * Claims 1-7; figures 1-3 * <br> --- | 1-4,7 | H 01 L 21/285 <br> H 01 L 21/00 <br> H 01 L 29/72 |
| A | DE-A-3 243 059 (SIEMENS AG) <br> * Claim 2; figures 3-5 * <br> --- | 1-4,7 | |
| A | US-A-4 381 953 (A.P. HO et al.) <br> --- | | |
| A | EP-A-0 096 155 (IBM CORP.) <br> ----- | | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 30-11-1987 | ZOLLFRANK G.O. |

EPO FORM 1503 03.82 (P0401)